# FASCICULE DE BREVET EUROPEEN

(11) **EP 0 829 934 B1**
(45) Date de publication et mention de la délivrance du brevet: **26.02.2003**
(21) Numéro de dépôt: 97402081.0
(22) Date de dépôt: 08.09.1997
(51) Int. Cl.: H01S 5/10, H01L 33/00

(54) **Procédé de fabrication d'un composant optoélectronique à semiconducteur et composant ou matrice de composants fabriqués selon ce procédé**
Herstellungsverfahren einer optoelektrischen Halbleitervorrichtung, und Vorrichtung oder Matrix von Vorrichtungen hergestellt unter Verwendung dieses Verfahrens
Method of fabricating an optoelectrical semiconductor device and a device or matrix of devices fabricated using said method

(30) Priorité: 13.09.1996 FR 9611198; 20.03.1997 FR 9703413
(43) Date de publication de la demande: 18.03.1998
(73) Titulaire: ALCATEL, 75008 Paris (FR)
(72) Inventeur: Goldstein, Léon, 92370 Chaville (FR); Brillouet, François, 92140 Clamart (FR); Fortin, Catherine, 91460 Marcoussis (FR); Jacquet, Joel, 91470 Limours (FR); Salet, Paul, 92140 Clamart (FR); Lafragette, Jean Luc, 91630 Marolles en Hurepoix (FR); Plais, Antonina, 75019 Paris (FR)
(74) Mandataire: Fournier, Michel Robert Marie

(56) Documents cités:
- FR-A- 2 694 988
- US-A- 4 632 712
- PATENT ABSTRACTS OF JAPAN vol. 018, no. 080 (E-1505), 9 février 1994 & JP 05 291698 A (NEC CORP), 5 novembre 1993,
- BABIC D I ET AL: "ROOM-TEMPERATURE CONTINUOUS-WAVE OPERATION OF 1.54-MU M VERTICAL- CAVITY LASERS" IEEE PHOTONICS TECHNOLOGY LETTERS, vol. 7, no. 11, 1 novembre 1995, pages 1225-1227, XP000537941
- PATENT ABSTRACTS OF JAPAN vol. 013, no. 461 (C-645), 18 octobre 1989 & JP 01 179797 A (NEC CORP), 17 juillet 1989,
- PATENT ABSTRACTS OF JAPAN vol. 013, no. 461 (C-645), 18 octobre 1989 & JP 01 179798 A (NEC CORP), 17 juillet 1989,
- PATENT ABSTRACTS OF JAPAN vol. 017, no. 353 (E-1393), 5 juillet 1993 & JP 05 055147 A (HIKARI GIJUTSU KENKYU KAIHATSU KK), 5 mars 1993,
- PATENT ABSTRACTS OF JAPAN vol. 095, no. 006, 31 juillet 1995 & JP 07 074066 A (HITACHI LTD), 17 mars 1995,
- SHIN H -E ET AL: "780NM OXIDISED VERTICAL-CAVITY SURFACE-EMITTING LASERS WITH AL0.11GA0.89AS QUANTUM" ELECTRONICS LETTERS, vol. 32, no. 14, 4 juillet 1996, page 1287/1288 XP000624424
- CHUA C L ET AL: "LOW-THRESHOLD 1.57- M VC-SEL'S USING STRAIN-COMPENSATED QUANTUM WELLS AND OXIDE/METAL BACKMIRROR" IEEE PHOTONICS TECHNOLOGY LETTERS, vol. 7, no. 5, 1 mai 1995, pages 444-446, XP000506775
- L.GOLDSTEIN, C. FORTIN, P. SALET, A. PLAIS ET AL: "metamorphic GaAs/AlAs Bragg mirrors deposited on InP for 1.3/1.55 mum vertical cavity lasers" 1997 DIGEST OF THE IEEE/LEOS SUMMER TOPICAL MEETINGS: VERTICAL CAVITY LASERS/TECHNOLOGY FOR A GLOBAL INFORMATION INFRASTRUCTURE/WDM COMPONENTS TECHNOLOGY/ADVANCED SEMICONDUCTOR LASERS AND APPLICATIONS/GALLIUM NITRIDE MATRIALS, 11 - 15 août 1997, MONTREAL CANADA, pages 49-50, XP002049291

## Description

La présente invention concerne la fabrication de composants optoélectroniques tels, notamment, que les lasers semiconducteurs à émission de surface du type dit VCSEL d'après l'anglais "Vertical Cavity Surface Emitting Laser". D'autres composants concernés par cette invention sont des diodes émettrices à microcavité et des filtres optiques accordables électriquement. Cette invention concerne plus particulièrement la fabrication de tels composants lorsque la lumière émise ou filtrée doit avoir une longueur d'onde de 1300 ou 1500 µm environ pour se situer dans l'une des fenêtres spectrales couramment utilisées dans les systèmes de communication à fibres optiques. Le fonctionnement du composant à une telle longueur d'onde est obtenu à l'aide d'une structure active qui est le siège de l'interaction optoélectronique spécifique de ce composant et qui est formée au sein d'une plaque monocristalline de phosphure d'indium InP. Le réseau cristallin de ce matériau est cubique.

Certains éléments d'un tel laser ou d'un autre composant sont cependant avantageusement constitués d'arséniure de gallium et/ou d'autres matériaux qui ont eux aussi un réseau cristallin cubique mais avec la maille cristalline de l'arséniure de gallium, qui est différente de celle du phosphure d'indium. Il s'agit notamment d'un miroir de Bragg constituant l'une des extrémités de la cavité optique d'un laser ou d'une diode électroluminescente à microcavité. Il peut s'agir aussi d'une couche de confinement électrique permettant de confiner ou d'uniformiser la densité du courant d'alimentation qui injecte des porteurs de charges dans la couche optiquement active incluse dans cette cavité. Un problème de compatibilité cristalline se pose alors en raison du fait qu'une bonne qualité cristalline apparaît comme essentielle pour un bon fonctionnement du laser aussi bien en ce qui concerne une plaque semiconductrice devant constituer par exemple la structure active d'un laser qu'en ce qui concerne d'autres éléments tels qu'un miroir de Bragg semiconducteur. Ce problème difficile est celui d'une réalisation convenable du raccordement du réseau cristallin de l'arséniure de gallium à celui du phosphure d'indium, cette réalisation devant être convenable en ce sens qu'elle doit être compatible avec le bon fonctionnement recherché.

Plusieurs procédés connus ont été proposés ou mis en oeuvre pour fabriquer un laser à émission de surface émettant aux longueurs d'ondes indiquées ci-dessus tout en évitant ou résolvant le problème ci-dessus.

Selon un premier procédé connu on évite ce problème, du moins en ce qui concerne le miroir de Bragg du laser, en constituant ce miroir par des couches alternées de phosphure d'indium et d'un matériau quaternaire GainAsP accordé en maille au phosphure d'indium. Le faible écart entre les indices de réfraction des deux matériaux oblige alors, compte tenu de la grande réflectance nécessaire, à former un grand nombre de paires de couches. Ce nombre est supérieur à 40 et entraîne une faible largeur de la bande optique du miroir et une grande résistance électrique. Cette dernière est gênante si le courant d'alimentation est injecté à travers ce miroir. Par ailleurs le matériau quaternaire introduit une résistance gênante à l'évacuation de la chaleur. Ce premier procédé connu est décrit dans une communication : High reflectivity semiconductor mirrors for 1,3 µm emitting lasers, P. Salet, C. Starck, A. Pinquier, Cleo 96.

Le même problème est encore évité par réalisation d'un accord de maille dans un deuxième procédé connu selon lequel les matériaux du miroir de Bragg ont des compositions Al In As et Ga Al In As. Les inconvénients de ce deuxième procédé connu sont analogues à ceux du premier.

Le même problème est encore évité par réalisation d'un accord de maille dans un troisième procédé connu selon lequel les matériaux du miroir de Bragg ont les compositions AlAsSb et AlGaAsSb. Ces matériaux tendent malheureusement à se décomposer en deux phases distinctes. Ce troisième procédé connu est décrit dans un article: AlAsSb : AlGaAsSb Bragg stacks for 1,55 µm wavelength grown by MBE, J.C.Harmand, F.Jeannès, G.Le Roux and M.Juhel Elec. Lett. Vo131, 1995, 1669.

Un quatrième procédé connu résout le problème en question, c'est à dire que le réseau cristallin du miroir de Bragg a la maille de l'arséniure de gallium et est raccordé à une plaque de phosphure d'indium. Les matériaux de ce miroir sont l'arséniure d'aluminium AlAs et l'arséniure de gallium. Ils permettent d'obtenir une grande réflectance et de faibles résistances thermique et électrique. Le miroir est formé par un procédé de dépôt épitaxial sur une deuxième plaque constituée d'arséniure de gallium. Cette deuxième plaque est soudée à la première par appui mutuel à 600°C sous hydrogène, l'ensemble des deux plaques ainsi liées pouvant être appelé "plaque composite".

Ce quatrième procédé connu est coûteux parce que les dimensions des plaques que l'on peut souder ainsi sont limitées. Une fabrication économique des lasers est en effet classiquement obtenue en réalisant des plaques de grande dimension qui peuvent éventuellement être ensuite découpées pour que chacune des parties ainsi séparées constitue un laser ou pour constituer une ou plusieurs matrices de lasers. En raison de leurs dimensions limitées les plaques composites formées par ce quatrième procédé connu ne peuvent pas constituer chacune un nombre suffisamment grand de lasers pour que le procédé soit économique. Par ailleurs la tension de seuil des lasers fabriqués est relativement élevée. Ce quatrième procédé est connu sous l'appellation internationale "wafer fusion" qui peut être remplacée en français pa "liaison par fusion". Il est décrit dans un article: D.I.Babic, K.Treubel, R.P.Mirin, N.M.Margalit, J.E.Bowers, E.L.Hu, D.E.Mars, L.Yang and K.Carey, Photon. Techn. lett. vol 7, 1225, 1995.

FR-A-2 694 988 divulgue une procédé de fabrication de composants optoélectroniques semiconducteurs et un composant optoélectronique semiconducteur selon les préambules respectifs des revendications 1 et 21.

La présente invention a notamment pour but de permettre la fabrication à faible coût de lasers à émission de surface ou de diodes électroluminescentes à microcavités émettant aux longueurs d'onde associées au phosphure d'indium tout en comportant un miroir de Bragg ou un autre élément ayant des qualités propres liées à l'arséniure de gallium et aux matériaux de même maille cristalline et tout en évitant que le raccordement des deux réseaux cristallins de mailles différentes nuise aux performances de ces lasers ou diodes. Elle a plus généralement pour but de permettre d'associer simplement et efficacement ces deux types de matériaux pour la fabrication d'un tel composant.

L'invention est définie par les revendications 1, 21 et 22. Divers modes de réalisation sont définis par les revendications dépendantes.

D'autres buts de la présente invention seront indiqués plus loin.

A l'aide des figures schématiques annexées on va exposer ci-après diverses dispositions utiles associées à la présente invention et on va décrire, à simple titre d'exemple, divers modes de mises en oeuvre de cette invention. Ces figures sont des vues en coupe de divers lasers à émission de surface à diverses étapes de leurs fabrications respectives. Lorsque deux éléments de même nature sont représentés sur deux de ces figures et assurent des fonctions équivalentes dans deux de ces divers lasers, respectivement, ils peuvent être désignés par les mêmes chiffres et/ou lettres de référence.

La figure 1 représente un premier et un deuxième lasers fabriqués selon deux modalités respectives d'un premier procédé conforme à cette invention.

La figure 2 représente un troisième et un quatrième lasers fabriqués selon deux autres modalités respectives dudit premier procédé conforme à cette invention.

Les figures 3 à 9 représentent des étapes successives de la fabrication d'une matrice de lasers selon un deuxième procédé conforme à cette invention, cette matrice incluant un cinquième laser.

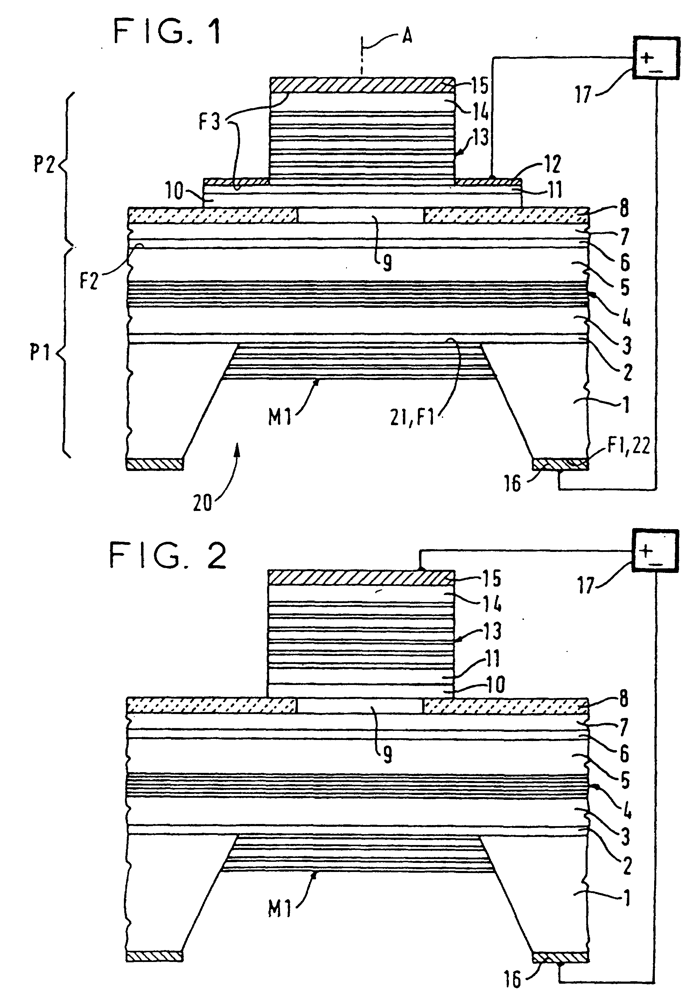

L'ordre de succession des couches semiconductrices représentées sur les figures 1 et 2 de bas en haut représente l'ordre de succession des étapes de dépôt de ces couches et les lasers représentés appartiennent à une matrice de tels lasers.

On considérera ci-après que les surfaces des plaques semiconductrices sont horizontales, l'épaisseur de ces plaques et des couches déposées sur ces plaques étant considérées comme verticales. Bien entendu les composants fabriqués peuvent être disposés selon n'importe quelle orientation.

De même que le quatrième procédé connu précédemment mentionné, le dit premier procédé conforme à cette invention comporte les opérations suivantes, les couches déposées par ces opérations étant représentées à la figure 1:
- Formation de la dite plaque à base de phosphure d'indium InP. Pour la description de ce premier procédé cette plaque sera parfois appelée ci-après "première plaque". Elle présente deux faces principales horizontales constituant une face inférieure F1 et une face supérieure F2. La structure active incluse dans cette plaque comporte de bas en haut :
   . une couche d'injection inférieure 3 d'un premier type de conductivité, qui, dans ce premier procédé de l'invention, est typiquement le type N,
   . une couche active 4 constituée d'un matériau actif à composition ternaire ou quaternaire ou constituée de puits quantiques et présentant la maille cristalline du phosphure d'indium, et
   . une couche d'injection supérieure 5 de l'autre type de conductivité qui est donc typiquement le type P.

Cette structure est destinée à être traversée par un courant d'alimentation ayant la direction verticale et un sens direct défini par les types de conductivité des couches d'injection. Elle est alors apte à amplifier une lumière dont la longueur d'onde est comprise entre 1200 et 2000 nm et est typiquement voisine de 1300 ou 1500 nm.
- Mise en place sur la face supérieure de la première plaque d'une deuxième plaque semiconductrice P2 constituée de matériaux ayant la maille cristalline de l'arséniure de gallium Ga As. La superposition des deux plaques forme une plaque composite présentant une face inférieure F1 et une face supérieure F3. Des éléments liés à la deuxième plaque pourront assurer diverses fonctions au sein du laser à fabriquer. Deux telles fonctions seront indiquées plus loin.
- Formation d'un miroir inférieur M1 sur la face inférieure et d'un miroir supérieur 13 sur la face supérieure de la plaque composite pour constituer une cavité optique résonante verticale pour le laser à fabriquer. L'un de ces miroirs est partiellement transparent pour permettre à la lumière de ce laser de s'échapper de cette cavité.
- Enfin formation d'une électrode inférieure 16 et d'une électrode supérieure 12 respectivement sur les faces inférieure et supérieure de la plaque composite pour permettre d'injecter ledit courant d'alimentation à travers la structure active.

Selon l'invention la mise en place de la deuxième plaque est remplacée par une opération de dépôt effectuée par ledit procédé de dépôt épitaxial. Cette opération fait croître progressivement des couches métamorphiques sur la face supérieure de la première plaque.

On sait que l'utilisation d'un procédé de dépôt épitaxial a habituellement pour conséquence de former des couches en continuité cristalline avec le substrat sur lequel le dépôt est effectué. Mais, dans le cadre de la présente invention, et compte tenu du désaccord de maille important entre l'arséniure de gallium et le phosphure d'indium, l'utilisation d'un tel procédé fait apparaître des contraintes mécaniques et des dislocations dans les réseaux cristallins des matériaux en contact. De très nombreuses dislocations se poursuivent dans l'épaisseur des couches déposées. De même que ces couches ce matériau peut alors être qualifié de "métamorphique". Par rapport à d'autres matériaux cristallisés de même composition il peut présenter une densité relativement élevée de dislocations et une répartition relativement uniforme de ces dislocations au voisinage de la plaque sur laquelle il a été déposé. Par ailleurs les contraintes appliquées au réseau cristallin de la première plaque peuvent y provoquer des dislocations. Or la formation de dislocations importantes dans la structure active contenue dans cette première plaque empêcherait le fonctionnement du laser. C'est peut être l'une des raisons pour lesquelles le quatrième procédé de fabrication connu précédemment mentionné incluait des étapes complexes pour ne pas avoir à utiliser un procédé de dépôt épitaxial pour la mise en place de la deuxième plaque. Cependant, dans le cadre de la présente invention, il a été envisagé que les contraintes induites par un tel procédé de dépôt dans le réseau cristallin de la première plaque restaient peut être limitées à une profondeur petite à partir de la face supérieure de cette plaque, et il a été en fait trouvé que le fonctionnement de la structure active sous jacente pouvait ne pas être sensiblement affecté par des dislocations provoquées par de telles contraintes.

Il a de plus été trouvé que certaines dispositions contribuaient utilement à préserver l'intégrité fonctionnelle de la structure active, tout en n'étant peut être pas indispensables. Selon l'une de ces dispositions l'opération de dépôt métamorphique est précédée par le dépôt d'une couche de blocage 6 ayant la maille cristalline du phosphure d'indium. Cette couche de blocage est constituée d'un matériau à composition quaternaire. Elle permet de bloquer efficacement les dislocations générées dans l'arséniure de gallium. Elle a par exemple la composition Ga _{0,2} ln _{0,8} As As _{0,44} P _{0,56.}

Le procédé de dépôt épitaxial utilisé est par exemple l'épitaxie par jet moléculaire. On pourrait cependant aussi utiliser la technique de croissance en phase vapeur dite MOVPE.

L'opération de dépôt métamorphique semble être avantageusement effectuée à une température inférieure à 500°C, par exemple 450 ou 400°C.

Selon une autre disposition présentant en outre d'autres avantages le miroir supérieur 13 est un miroir de Bragg. Il est constitué par une succession verticale alternée de couches constituées ou à base d'arséniure de gallium As Ga et de couches d'un matériau de contraste d'indice présentant un indice de réfraction sensiblement différent de celui de l'arséniure de gallium tout en présentant un accord de maille avec l'arséniure de gallium. Ce matériau de contraste d'indice est typiquement à base d'arséniure d'aluminium Al As. Il a par exemple la composition Al_{0,9} Ga_{0,1} As. Un tel miroir permet de manière connue d'obtenir une réflectance très élevée, voisine de 99,8%, au moins, ce qui est nécessaire au fonctionnement du laser et ne serait pas possible avec un miroir métallique. Dans le cadre de la présente invention il est apparu de manière surprenante que le fait qu'un miroir de Bragg semiconducteur soit constitué de couches métamorphiques ne diminuait pas sensiblement ses qualités et notamment n'introduisait pas de pertes de lumière susceptibles de gêner le fonctionnement d'un laser. Le miroir inférieur est alors très partiellement transparent. Il est par exemple du type multidiélectrique. Sa réflectance est par exemple voisine de 99,7%. Il est réalisé par les opérations suivantes :
- Attaque locale du substrat 1 à partir de la face inférieure F1 de la plaque P1 pour former un évidement 20. Cet évidement présente un fond 21. Il est suffisamment profond pour qu'une épaisseur diminuée de la plaque P1 entre ce fond et la face supérieure de cette plaque soit égale à l'épaisseur qui convient pour la cavité résonante. Cette épaisseur est à considérer selon l'axe A de cette cavité. Les dimensions superficielles de cet évidement sont limitées pour que la surface 22 présentée par cette plaque à l'extérieur de cet évidement soit suffisante pour conserver une dite résistance de manipulation à cette plaque.
- Puis dépôt de couches successives sur le fond 21 de l'évidement 20, ces couches présentant des indices de réfractions alternés et étant constituées de matériaux diélectriques.

Le fait que la plaque supérieure soit constituée par la superposition de nombreuses couches semiconductrices semble utile à la préservation de l'intégrité fonctionnelle de la couche active. Il a cependant été trouvé que le dépôt de ces couches semiconductrices dans des conditions de désaccord de maille pouvait faire apparaître des rugosités de surface dans les interfaces qui sont notamment formées entre des couches ayant des indices de réfraction différents. De telles rugosités peuvent entraîner des pertes de lumière par diffusion et de telles pertes pourraient empêcher l'oscillation optique de s'établir dans la cavité résonante. Selon l'invention il a cependant été trouvé que ces rugosités pouvaient être suffisamment limitées pour que la présence de telles couches dans la cavité optique résonante du laser soit compatible avec un bon fonctionnement de ce dernier.

Selon une disposition utile pour limiter de telles rugosités les couches semiconductrices 7, 9, 10, 13,14 superposées au sein de la deuxième plaque P2 contiennent une proportion d'indium comprise entre 0,1 et 5% en moles et de préférence entre 0,5 et 1% et par exemple voisine de 1%. L'adjonction d'indium permet de former des couches "lisses" sans rugosité.

En ce qui concerne les électrodes, au moins l'une d'entre elles doit être disposée latéralement à la cavité résonante optique. Il s'agit de l'électrode qui est située sur la même face principale que le miroir partiellement transparent. Cette électrode empêcherait la sortie de la lumière de cette cavité si elle était disposée dans l'axe A de celle-ci. Une telle localisation de l'une ou des deux électrodes tend à faire passer le courant d'alimentation à distance de la cavité résonante. Or il est souhaitable que, au niveau de la couche active, le courant d'alimentation soit confiné au voisinage de l'axe de cette cavité. Il est connu pour cela d'incorporer dans une plaque semiconductrice une couche qui est oxydée sur une partie de sa surface pour être électriquement isolante sauf au voisinage de la cavité optique. Le confinement du courant peut cependant aussi être obtenu par la disposition de l'électrode supérieure au dessus du miroir supérieur dont les dimensions horizontales sont limitées pour cela par une opération de gravure. Dans ce cas la couche partiellement oxydée reste typiquement utile pour uniformiser la densité du courant d'alimentation. Cette couche est avantageusement constituée par de l'arséniure d'aluminium AlAs qui présente la même maille cristalline que l'arséniure de gallium. C'est pourquoi, de préférence, l'opération de dépôt formant la deuxième plaque semiconductrice P2 comporte le dépôt d'une couche d'arséniure d'aluminium 9 et l'oxydation de cette couche dans une zone latérale 8 s'écartant de l'axe A de la cavité optique résonante.

On va maintenant décrire plus particulièrement quatre modes de mise en oeuvre de cette invention.

Conformément à la figure 1 des couches semiconductrices ont été déposées dans l'ordre indiqué ci-après pour fabriquer un premier laser selon la présente invention. Pour former d'abord une première plaque P1 les couches suivantes ont été constituées de phosphure d'indium InP sauf indication contraire:
- Un substrat 1 épais de 0, 1 mm et dopé N à 3.10¹⁸ cm-3
- Une couche d'arrêt de gravure 2 constituée de GalnAsP avec une longueur d'onde caractéristique 1180 nm. Cette couche est épaisse de 50 nm et dopée N à 1.10¹⁸ cm⁻³. Lors d'une gravure de la partie centrale de la face inférieure F1 de la plaque P1 cette couche a permis de limiter la profondeur de l'attaque pour former une surface sur laquelle a été déposé un miroir inférieur M1 constitué de couches diélectriques.
- Une couche d'injection inférieure 3 épaisse de 1 000 à 2 000 nm et dopée N à 1.10¹⁸ _{cm}⁻³.
- Une couche active 4 constituée d'un matériau ternaire ou quaternaire ou de multiples puits quantiques et ayant une longueur d'onde caractéristique de 1300 ou 1500 nm. Cette couche est épaisse de 100 à 1 000 nm et n'est pas dopée.
- Enfin une couche d'injection supérieure 5 épaisse de 100 à 2000 nm et dopée P à 2.10¹⁸ cm⁻³.

Sur la face supérieure F2 de la plaque P1 on a déposé une couche 6 constituée de GalnAsP et présentant une épaisseur telle que 30 nm, trop faible pour que cette couche puisse jouer un rôle optique.

Pour former la deuxième plaque P2 on a ensuite déposé les couches suivantes qui sont constituées d'arséniure de gallium sauf indication contraire:
- Une couche inférieure 7 épaisse de 300 à 500 nm et dopée P à 2.10¹⁸ cm⁻³. La zone périphérique de cette couche a été oxydée pour constituer un écran diélectrique 8 constitué d'un matériau AlOx et utile pour un confinement ou une uniformisation de la densité du courant d'alimentation.
- Une couche de contact 10 ayant une épaisseur optique égale au 3/4 de la longueur d'onde d'émission du laser et un dopage P à 3.10¹⁹ cm⁻³.
- Une couche d'arrêt de gravure 11 constituée de phosphure d'indium et de gallium GalnP. Les proportions d'indium et de gallium dans cette couche sont choisies pour réaliser un accord de maille avec l'arséniure de gallium. Cette couche est épaisse de 10 à 50 nm et n'est pas dopée. Elle aura pour rôle de limiter la profondeur d'attaque d'une gravure qui sera effectuée ultérieurement sur la face supérieure F3 de la plaque composite incluant les plaques P1 et P2 pour limiter latéralement le miroir supérieur 13 du laser.
- Le miroir supérieur 13. Ce miroir comporte de 20 à 30 paires de couches 5 constituées chacune de deux couches non dopées ayant une même épaisseur optique égale au quart de la longueur d'onde du laser. Le matériau de l'une des couches de chaque paire a la composition Ga _{0,1} Al _{0,9} As et est accordé en maille à celui de l'arséniure de gallium. Le matériau de l'autre couche est l'arséniure de gallium.
- Enfin une couche d'accord de phase 14 épaisse de 200 nm environ et non dopée. Cette couche a pour but d'introduire une distance optique convenable entre le miroir 13 et une couche métallique supérieure 15 qui réfléchit la lumière et coopère ainsi avec le miroir 13.

L'ensemble des couches 13 et 14 a été gravé pour limiter latéralement le miroir supérieur 13. Après cette gravure une couche métallique d'or Au et/ou de tungstène W a été déposée sur la face supérieure F3 de la plaque composite. Sur le miroir supérieur elle constitue un réflecteur complémentaire 15. Sur la couche 11 et la couche de contact 10 cette couche métallique constitue une électrode supérieure 12 autour du miroir 13.

Une électrode inférieure 16 a été déposée sur la face inférieure F1 autour du miroir inférieur M1. Le courant d'alimentation du laser sera ultérieurement fourni à ces électrodes par une source telle que 17.

La fabrication de trois autres lasers qui vont être donnés aussi en exemple de mise en oeuvre de l'invention est analogue à ce qui vient d'être décrit sauf sur les points indiqués ci-après.

Dans le deuxième laser représenté à la figure 1 le miroir supérieur 13 a été constitué par dépôt de couches diélectriques d'indices de réfraction alternés.

Dans le troisième laser représenté à la figure 2 le miroir 13 est constitué des mêmes paires de couches semiconductrices que dans le premier laser sauf que ces couches sont dopées P pour permettre d'injecter le courant d'alimentation du laser à partir du réflecteur complémentaire 15 qui constitue alors en même temps l'électrode 35 supérieure. Un rôle de conduction électrique analogue à celui qui était joué par la couche de contact est joué ici par la couche 14 qui est dopée en conséquence.

Dans le quatrième laser plus particulièrement analogue au troisième et également représenté à la figure 2, le miroir 13 est constitué des mêmes paires de couches que dans le troisième laser sauf que ces couches sont dopées N pour diminuer la résistance électrique et les pertes optiques présentées par le miroir. Les couches 7, 9, et 11 sont alors également dopées N et le courant d'alimentation est transmis par une jonction tunnel N/P formée par les couches 5 et 7.

Le deuxième procédé conforme à la présente invention diffère quelque peu du premier notamment parce qu'il permet d'atteindre non seulement les buts précédemment mentionnés mais aussi des buts supplémentaires, de sorte que ce deuxième procédé constitue un mode préféré de mise en oeuvre de cette invention. Ces buts supplémentaires seront indiqués après un exposé complémentaire des problèmes qui se posent pour la fabrication de composants tels que les lasers à émission de surface.

Comme précédemment indiqué un miroir de Bragg peut avantageusement être formé sur une plaque de phosphure d'indium P1 telle que précédemment décrite par dépôt de couches métamorphiques constituées de matériaux dont la maille cristalline naturelle serait celle de l'arséniure de gallium, l'un de ces matériaux étant typiquement l'arséniure de gallium lui même. Il peut donc être utile de constituer le miroir inférieur par de telles couches métamorphiques, ce qui n'est pas le cas du premier procédé conforme à l'invention. On sait par ailleurs que les deux miroirs constituant la cavité optique résonante d'un tel laser doivent être séparés par une distance qui est déterminée dans le but de permettre un bon fonctionnement de ce laser. Ces deux miroirs doivent donc être déposés sur les deux faces principales opposées d'une plaque telle que P1 de sorte qu'ils sont nécessairement séparés par l'épaisseur de celle-ci.

Or, au cours du processus de fabrication des lasers, diverses manipulations doivent être subies par une telle plaque. Pour permettre de fabriquer collectivement un nombre important de lasers d'une manière économique, cette plaque doit avoir une étendue assez importante. Pour résister à ces manipulations une plaque ayant une telle étendue doit présenter une épaisseur relativement importante, par exemple 0,1 mm Cette épaisseur est bien supérieure à la distance relativement faible qui doit séparer les deux miroirs de la cavité optique d'un laser, par exemple 0,04 mm. Un problème d'épaisseur est alors posé qui est de concilier à la fois l'épaisseur relativement importante qui est nécessaire pour permettre la manipulation de la plaque semiconductrice, et l'épaisseur relativement faible qui doit être interposée entre les deux miroirs formant la cavité optique de chacun des lasers à fabriquer.

Des procédés connus résolvent imparfaitement ce problème. Selon un premier tel procédé connu, les miroirs de chaque cavité optique sont des miroirs de Bragg à base d'arséniure de gallium. Chaque tel miroir doit être disposé sur une face, par exemple une face supérieure, d'une plaque à base de phosphure d'indium. Pour cela il a d'abord été fabriqué par dépôt épitaxial sur un substrat d'arséniure de gallium relativement épais. Puis il est assemblé à la plaque de phosphure d'indium par une liaison de fusion. Il la renforce mécaniquement de sorte que la face opposée de cette plaque, par exemple sa face inférieure, peut alors être attaquée pour amincir la plaque. Une deuxième opération du même type permet de déposer le deuxième miroir pour former la cavité optique. Ce premier procédé connu est coûteux parce que les dimensions des miroirs et des plaques que l'on peut assembler ainsi sont limitées, ce qui limite le nombre de lasers susceptibles d'être fabriqués à partir d'une même plaque. De plus les dislocations cristallines apparaissent à l'interface entre la plaque et les miroirs qui lui sont assemblés par une liaison de fusion et ces dislocations sont telles qu'elles affectent le fonctionnement du laser fabriqué par ce procédé. Enfin ce procédé nécessite l'utilisation de trois substrats semiconducteurs.

Selon un deuxième procédé connu pour résoudre ce problème d'épaisseur une plaque est fabriquée par dépôt épitaxial de la structure active sur la face supérieure d'un substrat de phosphure d'indium relativement épais 1. Des miroirs localisés à couches diélectriques sont déposés sur la face supérieure de cette plaque. Puis, comme précédemment décrit pour la fabrication du premier laser représenté à la figure 1, la face inférieure de ce substrat est attaquée localement à travers un masque pour former un évidement pour chaque puce. Des miroirs à couches diélectriques sont ensuite déposés au fond de ces évidements pour inclure chaque puce dans une cavité optique. Ce deuxième procédé connu présente les inconvénients suivants :
- La plaque semiconductrice est fragilisée par le creusement des évidements, même alors que des intervalles intacts subsistent entre les évidements.
- La mise en oeuvre du procédé est longue et délicate.
- Les flancs des évidements sont fortement inclinés par rapport à la direction verticale. Le fait que ces évidements ne se recouvrent pas mutuellement se traduit alors par une distance importante entre les miroirs déposés sur leurs fonds. Ceci entraîne entre les lasers un espacement important, supérieur à 0,5 mm, et limite donc le nombre de lasers susceptibles d'être fabriqués à partir d'une même plaque.

La présente invention a notamment pour buts supplémentaires :
- de permettre une fabrication économique et sûre de composants optoélectroniques tels que des lasers semiconducteurs à émission de surface devant émettre aux longueurs d'onde associées au phosphure d'indium,
- de permettre une bonne isolation électrique entré des composants formés sur une même plaque pour constituer une matrice de lasers, et
- de permettre une bonne dissipation de la chaleur engendrée dans la structure active d'un composant ainsi fabriqué.

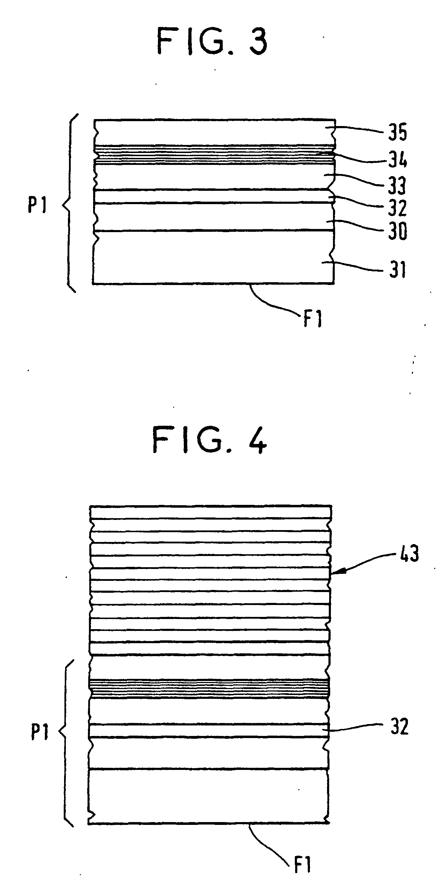

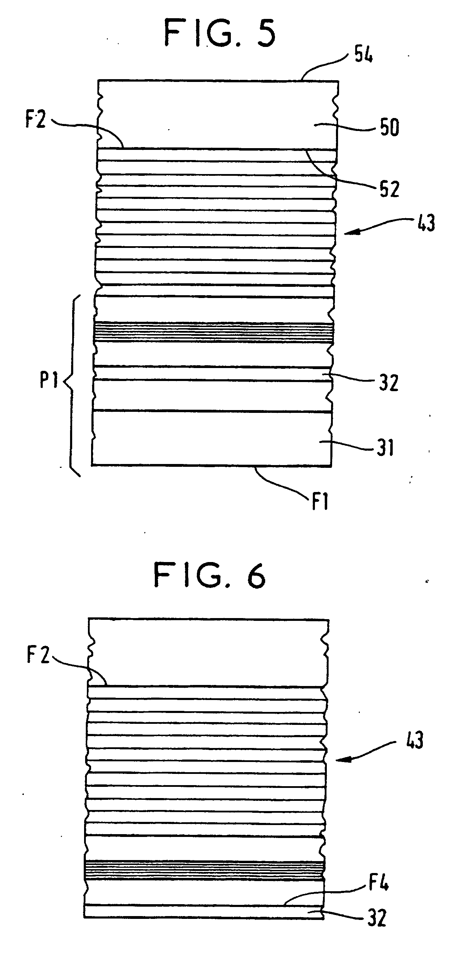

Les figures 3 à 9 illustrent le deuxième procédé qui est conforme à cette invention et qui permet d'atteindre ces buts supplémentaires. Lorsque des éléments représentés sur ces figures sont analogues à des éléments représentés aux figures 1 et 2, ils peuvent être désignés soit par les mêmes lettres et/ou nombres de référence, soit par des nombres de référence augmentés du nombre 30, la couche 31 de la figure 3 étant par exemple analogue à la couche 1 de la figure 1. Par ailleurs, sur les figures 5 à 9 l'ordre des opérations de dépôt des nouvelles couches représentées correspond à l'ordre dans lequel ces couches se succèdent de haut en bas sur ces figures.

Les étapes du deuxième procédé conforme à cette invention vont être décrites d'abord d'une manière générale convenant aussi pour le premier procédé, puis d'une manière spécifique correspondant seulement à ce deuxième procédé. Il doit être compris que pour limiter les répétitions, certaines opérations non essentielles sont décrites pour un seul de ces deux procédés alors qu'elles sont aussi utiles pour l'autre.

Des opérations essentielles communes aux deux procédés sont les suivantes :
- Formation de la plaque P1. Cette plaque présente une épaisseur entre une face inférieure F1 et une face supérieure F2. Cette épaisseur est suffisante pour conférer à cette plaque une résistance mécanique permettant sa manipulation. Une telle résistance mécanique sera appelée ci-après "résistance de manipulation".
- Formation d'au moins un miroir supérieur 13 ou 43 sur la face supérieure de la plaque. Ce miroir supérieur est un miroir de Bragg. Il est formé par le dépôt d'une succession verticale de couches métamorphiques constituées alternativement d'un matériau telle que l'arséniure de gallium AsGa et d'un matériau de contraste d'indice tel que précédemment décrit à propos du premier procédé. Ces couches constituent des couches de miroir supérieur.
- Formation d'au moins un miroir inférieur M1 ou M2 sur la face inférieure de la plaque P1 pour constituer une cavité optique résonante verticale pour chaque composant à fabriquer. Chaque telle cavité résonante est constituée par l'ensemble d'un miroir inférieur et d'un miroir supérieur se faisant mutuellement face selon l'axe A de cette cavité. L'un au moins de ces deux miroirs est partiellement transparent pour permettre de coupler optiquement cette cavité à un organe extérieur au composant.
- Enfin formation d'une électrode inférieure 16 ou 46 et d'une électrode supérieure 12, 15 ou 45, respectivement sur les faces inférieure et supérieure de la plaque P1, pour permettre d'appliquer un signal électrique de commande à travers cette plaque pour chaque composant à fabriquer.

Plus particulièrement la plaque P1 est formée par des opérations de dépôts épitaxiaux sur un substrat 1 ou 31 ayant un premier type de conductivité. Ce premier type de conductivité est le type n ou le type p selon que l'on considère le premier et le deuxième procédé donné en exemple, respectivement. Ces opérations incluent successivement:
- le dépôt d'une couche tampon 30 ayant le premier type de conductivité,
- le dépôt d'une couche dopée inférieure 3 ou 33 ayant le premier type de conductivité,
- le dépôt d'une couche active 4 ou 34, et
- le dépôt d'une couche dopée supérieure 5 ou 35 ayant un deuxième type de conductivité opposé au premier pour constituer une structure active. Typiquement le signal électrique de commande est un courant d'alimentation pour injecter des porteurs de charges dans ladite couche active à partir des couches dopées inférieure et supérieure, ledit composant étant un laser à émission de surface ou une diode électroluminescente à microcavité. Ce composant pourrait cependant aussi être un modulateur d'amplitude à électroabsorption, un modulateur de phase ou un filtre accordable, par exemple. La couche active n'aurait pas alors la fonction d'amplification mais une fonction d'absorption ou de déphasage de la lumière. La lumière émise modulée ou filtrée par ledit composant sera appelée ci-après "lumière de ce composant", le trajet suivi par cette lumière dans ce composant constituant le "trajet optique fonctionnel" précédemment mentionné. Ce trajet optique s'étend sur la partie de l'axe A qui est à l'intérieur de la cavité optique.

Selon l'invention ce procédé est typiquement appliqué à la fabrication d'une matrice de composants comportant une pluralité de composants optoélectroniques mutuellement juxtaposés dans une surface de cette matrice. Certaines des opérations sont des opérations de fabrication collective réalisées par le dépôt ou l'élimination d'au moins une couche s'étendant sur l'ensemble de la surface de la matrice à fabriquer. Une couche déposée par une telle opération de fabrication collective constitue une couche collective telle que 46. La plaque P1 est formée par un ensemble de telles opérations, cet ensemble constituant lui même une telle opération. Le procédé inclut alors en outre au moins une opération de séparation. Chaque telle opération de séparation inclut une gravure localisée d'une couche collective pour isoler mutuellement une pluralité d'aires de cette couche collective et affecter respectivement ces aires aux composants optoélectroniques à fabriquer.

Plus spécifiquement dans le deuxième procédé selon l'invention l'opération de formation d'au moins un miroir inférieur comporte elle même les opérations de fabrication collective suivantes :
- Préparation d'un support 50 ayant une face inférieure 52 et une face supérieure 54 et ayant une épaisseur lui conférant une résistance mécanique constituant une dite résistance de manipulation.
- Mise en place de ce support au dessus de ladite face supérieure F2 de la plaque P1.
- Fixation de ce support à cette plaque par une liaison de fusion. Cette liaison de fusion est réalisée par appui à chaud de la face inférieure 52 de ce support sur chaque miroir supérieur 43.
- Attaque de la plaque P1 à partir de sa face inférieure F1. Cette attaque élimine le substrat 31 puis la couche d'arrêt de gravure 32 pour donner à cette plaque une épaisseur souhaitée pour la cavité résonante. Elle remplace la face inférieure F1 par une nouvelle face inférieure F4.
- Enfin dépôt de couches successives sur cette nouvelle face inférieure, ces couches constituant des couches collectives et présentant des indices de réfraction alternés pour constituer chaque miroir inférieur tel que M2. Ce miroir est un miroir de Bragg formé par le dépôt d'une succession verticale de couches métamorphiques constituées comme précédemment indiqué. Ces couches constituent des couches de miroir inférieur.

L'opération de formation d'une électrode inférieure 46 inclut :
- une opération de fabrication collective réalisée par le dépôt d'une couche d'électrode inférieure constituant une couche collective, et
- une opération de séparation constituée par une gravure de la couche d'électrode inférieure.

L'opération de dépôt d'au moins un miroir inférieur M2 inclut :
- une opération de fabrication collective réalisée par le dépôt des couches de miroir inférieur, et
- une opération de séparation constituée par une gravure de ces couches de miroir inférieur.

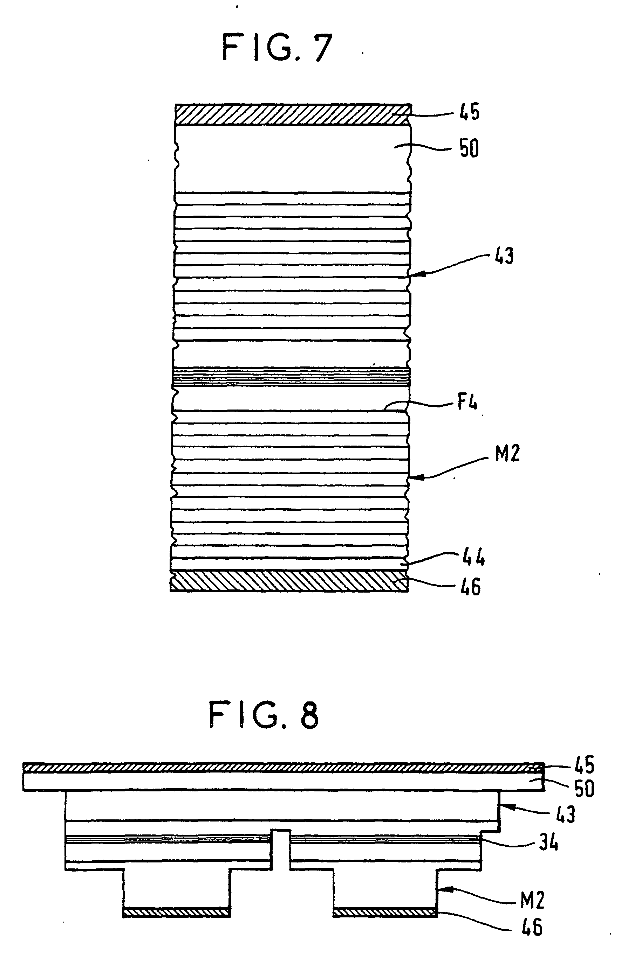

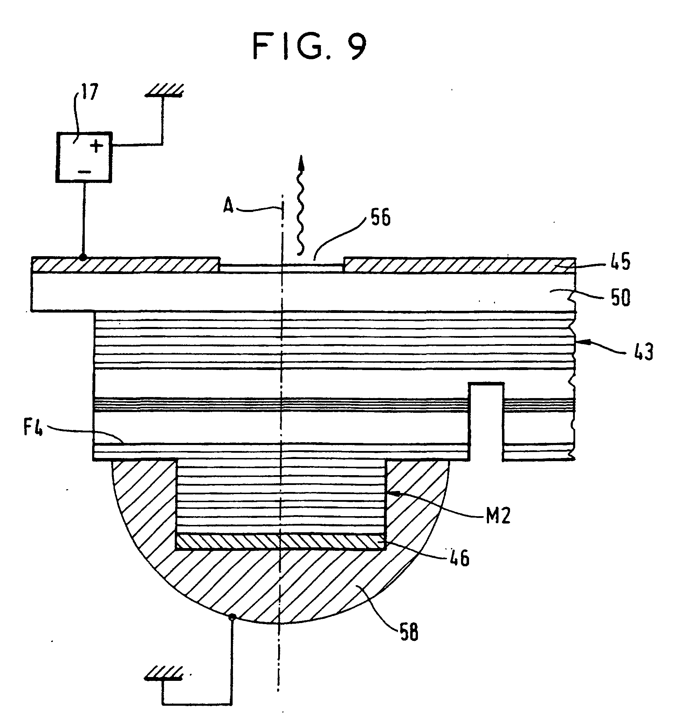

Conformément aux figures 8 et 9 une opération de séparation complémentaire attaque la plaque P1 à partir de sa dite face inférieure jusque dans la couche d'injection supérieure.

De préférence le miroir supérieur 43 est partiellement transparent et a le deuxième type de conductivité, le support 50 est semiconducteur et transparent et a lui aussi ledit deuxième type de conductivité. L'opération de formation d'une électrode supérieure inclut alors :
- une opération de dépôt collectif réalisée par le dépôt d'une couche d'électrode supérieure 45 sur la face supérieure 54 du support 50, et
- une opération de gravure formant dans cette couche d'électrode supérieure une fenêtre 56 pour chaque composant à fabriquer. Cette fenêtre s'étend autour de l'axe A de la cavité optique de ce composant pour permettre le passage de la lumière de ce composant.

De préférence le support 50 est constitué de silicium. D'autres modes de mise en oeuvre de l'invention sont cependant possibles dans lesquels ni la lumière ni le courant électrique d'alimentation du composant n'auraient à traverser ce support. Ce support pourrait alors être aussi bien constitué d'un autre matériau tel que le nitrure d'aluminium.

De préférence le procédé inclut en outre une opération de formation d'un évacuateur thermique 58 pour chaque composant à fabriquer. Cette opération est réalisée en déposant une masse d'un matériau bon conducteur thermique tel que de l'or sur la face inférieure F1 de la plaque, sur le miroir inférieur M2 et/ou sur l'électrode inférieure 46 de ce composant.

Cette disposition présente l'avantage que l'évacuateur thermique est aussi proche que possible de la source de chaleur constituée par la structure active du composant. Tel ne serait pas le cas si la chaleur devait traverser le support pour pouvoir être évacuée.

Plus particulièrement on peut donner à titre d'exemple les valeurs numériques et compositions suivantes pour la mise en oeuvre du deuxième procédé conforme à l'invention. Sauf indication contraire les couches de la plaque P1 sont constituées de phosphure d'indium InP.
- Substrat 31 : épaisseur de 0,25 ou 0,3 mm, diamètre : 50 mm.
- Couche tampon 30 : épaisseur 1 000 nm.
- Couche d'arrêt de gravure 32 : matériau quaternaire GalnAsP, de longueur d'onde caractéristique 1 180 nm, épaisseur 150 nm.
- Couche dopée d'injection inférieure 33 : dopage P à 1.10¹⁸ cm⁻³, épaisseur 270 nm.
- Couche active 34 : de 7 à 9 puits quantiques épais de 10 nm avec longueur d'onde caractéristique 1 550 nm séparés par des barrières épaisses de 10 nm avec longueur d'onde caractéristique 1 180 nm.
- Couche d'injection supérieure 35 : dopage N à 1.10¹⁸ cm⁻³, épaisseur 270 nm.
- Miroir supérieur 43 : 23,5 paires de couches constituées alternativement de AlAs et de GaAs, épaisses de 100nm environ et dopées N à 1.10¹⁸cm⁻³.
- Le support de silicium cristallin 50 est épais de 0,3 mm et a 75 mm de diamètre.
- La liaison de fusion entre le miroir supérieur 43 et le support 50 est réalisée à 600 ou 700°C sous flux d'hydrogène avec une pression de 30 à 150 g/cm² et une durée de 20 minutes à une heure.
- Le miroir inférieur M2 est déposé par épitaxie par jet moléculaire. Il diffère du miroir 43 seulement par son type de dopage qui est le type P.
- Une couche de contact inférieure 44 est épaisse de 100 nm et dopée P à 3.10¹⁹ _{cm}^{-3.}

De ce qui précède il apparaît qu'une matrice de composants optoélectroniques réalisée selon le deuxième procédé conforme à l'invention comporte au moins les éléments suivants :
- Une plaque cristalline P1 ayant la maille du phosphure d'indium, et ayant une résistance mécanique propre inférieure à une résistance mécanique souhaitée pour la matrice.
- Des couches métamorphiques 43, M2 constituées de matériaux cristallisables avec la maille de l'arséniure de gallium. Ces couches métamorphiques sont formées sur la plaque P1 et sont disposées en série avec cette plaque sur un trajet optique fonctionnel A de chacun des composants de la matrice.
- Enfin un support 50 constitué d'un matériau différent de ceux des couches métamorphiques et de la plaque P1. Ce support a une résistance mécanique supérieure à la résistance mécanique de la plaque. Il est fixé directement aux couches métamorphiques 43 par une liaison de fusion pour conférer la résistance mécanique souhaitée à la matrice.

La description ci-dessus a plus particulièrement concerné la fabrication de lasers.

La fabrication d'une diode émettre à microcavité diffère essentiellement de celle d'un laser du genre ci-dessus par la longueur de la cavité entre les deux miroirs et par la réflectance de ces miroirs. Les valeurs à réaliser pour cette longueur et ces réflectances dans le cadre de la présente invention sont les mêmes que celles qui sont bien connues des spécialistes pour de telles diodes en dehors de ce cadre.

La fabrication d'un filtre accordable se différencie en outre notamment par le fait que les deux miroirs doivent être partiellement transparents et par le fait que la structure active fonctionne avec une polarisation électrique différente, et, de plus, éventuellement variable. Là aussi les valeurs à réaliser pour ces grandeurs sont celles qui sont bien connues des spécialistes.

## Revendications

1. Procédé de fabrication de composants optoélectroniques semiconducteurs, ce procédé comportant au moins une opération de dépôt métamorphique utilisant un procédé de dépôt épitaxial pour déposer au moins un matériau cristallisable (7, 9, 10, 13) avec la maille de l'arséniure de gallium sur une plaque cristalline (P1) ayant la maille du phosphure d'indium, de manière que ce matériau cristallisable forme au moins une couche métamorphique (7, 9, 10, 13, 43) disposée en série avec cette plaque sur un trajet optique fonctionnel (A) de ce composant, ledit dépôt métamorphique formant au moins un miroir semiconducteur (13, M1) d'une structure laser, ce procédé étant **caractérisé par le fait que** ladite plaque cristalline (P1) ayant la maille du phosphure d'indium contient la couche active (4) de ladite structure laser.

2. Procédé de fabrication selon la revendication 1, ce procédé incluant les opérations de
- formation de la dite plaque (P1), cette plaque présentant une épaisseur entre une face inférieure (F1) et une face supérieure (F2), cette épaisseur étant suffisante pour conférer à cette plaqué une résistance mécanique permettant la manipulation de cette plaque, une telle résistance mécanique constituant une résistance de manipulation,
- formation d'au moins un miroir supérieur (13, 43) sur ladite face supérieure de ladite plaque, ce miroir supérieur étant un miroir de Bragg et étant formé par le dépôt d'une succession verticale de dites couches métamorphiques constituées alternativement d'un matériau à base d'arséniure de gallium As Ga et d'un matériau de contraste d'indice présentant un indice de réfraction sensiblement différent de celui de l'arséniure de gallium tout en présentant un accord de maille avec l'arséniure de gallium, ces couches constituant des couches de miroir supérieur,
- formation d'au moins un miroir inférieur (M1,M2) sur ladite face inférieure de ladite plaque pour constituer une cavité optique résonante verticale ayant un axe (A) pour chaque dit composant à fabriquer, chaque dite cavité résonante étant constituée par l'ensemble d'undit miroir inférieur et d'undit miroir supérieur se faisant mutuellement face selon ledit axe, l'un au moins des dits miroirs inférieur et supérieur étant partiellement transparent pour permettre de coupler optiquement cette cavité à un organe extérieur audit composant, et
- formation d'une électrode inférieure (16, 46) et d'une électrode supérieure (12, 15, 45) respectivement sur les faces inférieure et supérieure de ladite plaque pour permettre d'appliquer un signal électrique de commande à travers cette plaque pour chaque dit composant à fabriquer.

3. Procédé selon la revendication 2, ce procédé étant **caractérisé par le fait que** ladite opération de dépôt métamorphique débute par le dépôt d'une couche de blocage (6) à ctimposition quaternaire.

4. Procédé selon la revendication 1, ce procédé étant **caractérisé par le fait que** ledit procédé de dépôt épitaxial est l'épitaxie par jet moléculaire.

5. Procédé selon la revendication 2, ce procédé étant **caractérisé par le fait que** lesdites couches métamorphiques (P2) contiennent une proportion d'indium comprise entre 0,1 et 5% en moles.

6. Procédé selon la revendication 5, ladite proportion d'indium étant comprise entre 0,5 et 1%.

7. Procédé selon la revendication 2, ladite plaque (P1) étant formée par des opérations de dépôts épitaxiaux sur un substrat (1, 31) ayant un premier type de conductivité, ces opérations incluant successivement :
- le dépôt d'une couche dopée inférieure (3, 33) ayant ledit premier type de conductivité,
- le dépôt d'une couche active (4, 34), et
- le dépôt d'une couche dopée supérieure (5, 35) ayant un deuxième type de conductivité opposé au premier pour constituer une structure active.

8. Procédé selon la revendication 7, ce procédé étant **caractérisé par le fait qu'**une dite opération de dépôt métamorphique comporte le dépôt d'une couche d'arséniure d'aluminium (9) et l'oxydation de cette couche dans une zone latérale (8) s'écartant dudit axe (A) de la cavité résonante.

9. Procédé selon la revendication 7, ce procédé étant appliqué à la fabrication d'une matrice de composants comportant une pluralité de dits composants optoélectroniques mutuellement juxtaposés dans une surface de cette matrice, certaines des dites opérations étant des opérations de fabrication collective réalisées par le dépôt ou l'élimination d'au moins une couche s'étendant sur l'ensemble de ladite surface de la matrice, une couche déposée par une dite opération de fabrication collective constituant une couche collective (46), ladite opération de formation de ladite plaque {P1) étant une dite opération de fabrication collective, ledit procédé incluant en outre au moins une opération de séparation, chaque dite opération de séparation incluant une gravure localisée d'une dite couche collective pour isoler mutuellement une pluralité d'aires de cette couche collective et affecter respectivement ces aires auxdits composants optoélectroniques à fabriquer.

10. Procédé selon la revendication 9, ladite opération de formation d'au moins un miroir inférieur comportant elle même les opérations suivantes pour chaque dite cavité résonante :
- attaque locale dudit substrat (1) à partir de ladite face inférieure (F1) de la plaque (P1) pour former un évidement (20) présentant un fond (21), cet évidement étant suffisamment profond pour qu'une épaisseur diminuée de ladite plaque entre ce fond et ladite face supérieure de cette plaque soit égale à une épaisseur souhaitée pour ladite cavité résonante selon ledit axe (A) de cette cavité, des dimensions superficielles de cet évidement étant limitées pour qu'une surface (22) présentée par cette plaque à l'extérieur de cet évidement soit suffisante pour conserver une dite résistance de manipulation à cette plaque, et
- dépôt de couches successives sur le fond (21) de cet évidement, ces couches présentant des indices de réfraction alternés pour constituer un dit miroir inférieur (M1).

11. Procédé selon la revendication 10, lesdites couches du miroir inférieur (M1) étant des couches diélectriques.

12. Procédé selon la revendication 9, ladite opération de formation d'une électrode supérieure (15, 45) incluant :
- une dite opération de fabrication collective réalisée par le dépôt d'une couche d'électrode supérieure constituant une dite couche collective, et
- une dite opération de séparation constituée par une gravure de ladite couche d'électrode supérieure.

13. Procédé selon la revendication 12, ladite opération de dépôt d'au moins un miroir supérieur (13) incluant:
- une dite opération de fabrication collective réalisée par le dépôt des dites couches de miroir supérieur, et
- une dite opération de séparation constituée par une gravure de ces couches de miroir supérieur.

14. Procédé selon la revendication 9, ce procédé étant **caractérisé par le fait que** ladite opération de formation d'au moins un miroir inférieur comporte elle même des dites opérations de fabrication collective incluant les opérations de :
- préparation d'un support (50) ayant une face inférieure (52) et une face supérieure (54) et ayant une épaisseur lui conférant une résistance mécanique constituant une dite résistance de manipulation,
- mise en place de ce support au dessus de ladite face supérieure (F2) de la plaque (P1),
- fixation de ce support à cette plaque par une liaison de fusion, cette liaison de fusion étant réalisée par appui à chaud de ladite face inférieure (52) de ce support sur chaque dit miroir supérieur (43),
- attaque de ladite plaque (P1) à partir de sa dite face inférieure (F1) pour donner à cette plaque une épaisseur souhaitée pour ladite cavité résonante en remplaçant cette face inférieure par une nouvelle face inférieure (F4), et
- dépôt de couches successives sur cette nouvelle face inférieure, ces couches constituant des dites couches collectives et présentant des indices de réfraction alternés pour constituer chaque dit miroir inférieur (tel que M2).

15. Procédé selon la revendication 14, le dit miroir inférieur (M2) étant un miroir de Bragg formé par le dépôt d'une succession verticale de dites couches métamorphiques à base d'arséniure de gallium As Ga et d'un matériau de contraste d'indice présentant un indice de réfraction sensiblement différent de celui de l'arséniure de gallium tout en présentant un accord de maille avec l'arséniure de gallium, ces couches constituant des couches de miroir inférieur.

16. Procédé selon la revendication 14, ladite opération de formation d'une électrode inférieure (46) incluant :
- une dite opération de fabrication collective réalisée par le dépôt d'une couche d'électrode inférieure constituant une dite couche collective, et
- une dite opération de séparation constituée par une gravure de ladite couche d'électrode inférieure.

17. Procédé selon la revendication 16, ladite opération de dépôt d'au moins un miroir inférieur (M2) incluant :
- une dite opération de fabrication collective réalisée par le dépôt des dites couches de miroir inférieur, et
- une dite opération de séparation constituée par une gravure de ces couches de miroir inférieur.

18. Procédé selon la revendication 15, ce procédé étant **caractérisé par le fait que** ledit miroir supérieur (43) est partiellement transparent et a le deuxième type de conductivité, ledit support (50) étant semiconducteur et transparent et ayant lui aussi ledit deuxième type de conductivité, ladite opération de formation d'une électrode supérieure incluant :
- une dite opération de dépôt collectif réalisée par le dépôt d'une couche d'électrode supérieure (45) sur ladite face supérieure (54) du support (50), et
- une opération de gravure formant dans cette dite couche d'électrode supérieure une fenêtre (56) pour chaque dit composant, cette fenêtre s'étendant autour du dit axe (A) de la cavité optique de ce composant pour permettre le passage de la lumière de ce composant.

19. Procédé selon la revendication 18, ce procédé étant **caractérisé par le fait que** le dit support (50) est constitué de silicium.

20. Procédé selon la revendication 18, ce procédé étant **caractérisé par le fait qu'**il inclut en outre une opération de formation d'un évacuateur thermique (58) pour chaque dit composant, cette opération étant réalisée en déposant une masse d'un matériau bon conducteur thermique sur ladite face inférieure (F1) de la plaque, sur ledit miroir inférieur (M2) et/ou sur ladite électrode inférieure (46) de ce composant.

21. Composant optoélectronique semiconducteur comportant :
- une plaque cristalline (P1) ayant la maille du phosphure d'indium, et
- des couches métamorphiques (13, 43, M1, M2) constituées de matériaux cristallisables avec la maille de l'arséniure de gallium et disposées sur ladite plaque en série avec cette plaque sur un trajet optique fonctionnel (A) de ce composant, ledit dépôt métamorphique formant au moins un miroir semiconducteur (13, M1) d'une structure laser,
ce composant étant **caractérisé par le fait que** ladite plaque cristalline (P1) ayant la maille du phosphure d'indium contient la couche active (4) de ladite structure laser.

22. Matrice de composants optoelectroniques à semiconducteur, cette matrice étant **caractérisée par le fait qu'**elle comporte :
- une plaque cristalline (P1) ayant la maille du phosphure d'indium contenant une couche active (4) d'une structure laser, et ayant une résistance mécanique propre inférieure à une résistance mécanique souhaitée pour ladite matrice,
- des couches métamorphiques (43, M2) constituées de matériaux cristallisables avec la maille de l'arséniure de gallium, ces couches métamorphiques étant déposées sur ladite plaque et étant disposées en série avec cette plaque sur un trajet optique fonctionnel (A) de chacun des composants de ladite matrice, et
- un support (50) constitué d'un matériau différent de ceux desdites couches métamorphiques et de ladite plaque, ce support ayant une résistance mécanique supérieure à ladite résistance mécanique de la plaque, et étant fixé directement à desdites couches métamorphiques (43) par une liaison de fusion pour conférer la dite résistance mécanique souhaitée à ladite matrice.

## Patentansprüche

1. Verfahren zur Herstellung von halbleitenden optoelektronischen Bauteilen, wobei dieses Verfahren wenigstens einen Schritt für eine metamorphe Abscheidung umfasst, bei welcher eine epitaxiale Abscheidung verwendet wird um wenigstens ein kristallisierbares Material (7, 9, 10, 13) mit dem Gitter von Galliumarsenid auf einer kristallinen Platte (P1) mit dem Gitter von Indiumphosphid abzuscheiden, derart, dass dieses kristallisierbare Material wenigstens eine metamorphe Schicht (7, 9, 10, 13, 43) bildet, die in Reihe mit dieser Platte auf einer funktionellen optischen Bahn (A) dieses Bauteils angeordnet ist, welche metamorphe Abscheidung wenigstens einen halbleitenden Spiegel (13, M1) einer Laserstruktur bildet, wobei dieses Verfahren **dadurch gekennzeichnet ist, dass** die genannte kristalline Platte (P1) mit dem Gitter von Indiumphosphid die aktive Schicht (4) der genannten Laserstruktur enthält.

2. Verfahren zur Herstellung nach Anspruch 1, welches Verfahren die Schritte umfasst
- Bildung der genannten Platte (P1), wobei diese Platte eine Dicke zwischen einer unteren Seite (F1) und einer oberen Seite (F2) aufweist, welche Dicke ausreicht um dieser Platte eine die Bearbeitung dieser Platte ermöglichende mechanische Festigkeit zu verleihen, nämlich eine Bearbeitungsfestigkeit,
- Bildung wenigstens eines oberen Spiegels (13, 43) auf der oberen Seite der Platte, wobei dieser obere Spiegel ein Bragg-Spiegel ist und durch das Abscheiden einer vertikalen Abfolge der genannten metamorphen Schichten gebildet ist, welches abwechselnd bestehen aus einem Material auf Basis von Galliumarsenid GaAs und einem Indexkontrastmaterial, das einen Brechungsindex aufweist, der im wesentlichen verschieden von dem des Galliumarsenids ist, während es im Gitter mit demjenigen des Galliumarsenids abgestimmt ist, wobei diese Schichten obere Spiegelschichten bilden,
- Bildung wenigstens eines unteren Spiegels (M1, M2) auf der unteren Seite der Platte um einen vertikalen optischen Resonanzhohlraum mit einer Achse (A) für jedes herzustellende Bauteil zu bilden, wobei jeder Resonanzhohlraum durch die Anordnung des unteren Spiegels und des oberen Spiegels gebildet ist, welche sich entlang der Achse einander gegenüberliegen, wobei wenigstens einer der unteren und oberen Spiegel teilweise durchlässig ist um es zu ermöglichen, diesen Hohlraum an ein äußeres Organ des Bauteils optisch zu koppeln, und
- Bildung einer unteren Elektrode (16, 46) und einer oberen Elektrode (12, 15, 45), jeweils auf den unteren und oberen Seiten der Platte, um es zu ermöglichen ein elektrisches Steuersignal durch diese Platte hindurch für jedes herzustellende Bauteil anzulegen.

3. Verfahren nach Anspruch 2, welches Verfahren **dadurch gekennzeichnet ist, dass** der Schritt für eine metamorphe Abscheidung mit dem Abscheiden einer eine quaternäre Zusammensetzung aufweisenden Sperrschicht (6) beginnt.

4. Verfahren nach Anspruch 1, welches Verfahren **dadurch gekennzeichnet ist, dass** die epitaxiale Abscheidung die Molekularstrahlepitaxie ist.

5. Verfahren nach Anspruch 2, welches Verfahren **dadurch gekennzeichnet ist, dass** die metamorphen Schichten (P2) einen Anteil von Indium enthalten, der zwischen 0,1 und 5 Mol-% liegt.

6. Verfahren nach Anspruch 5, bei welchem der Anteil von Indium zwischen 0,5 und 1 Mol-% liegt.

7. Verfahren nach Anspruch 2, bei welchem die Platte (P1) durch die epitaxialen Abscheidungen auf ein Substrat (1, 31) mit einem ersten Leitungstyp gebildet wird, wobei diese Schritte aufeinanderfolgend umfassen:
- das Abscheiden einer dotierten unteren Schicht (3, 33) mit dem ersten Leitungstyp,
- das Abscheiden einer aktiven Schicht (4, 34), und
- das Abscheiden einer dotierten oberen Schicht (5, 35) mit einem zweiten Leitungstyp, der dem ersten entgegengesetzt ist, um eine aktive Struktur zu bilden.

8. Verfahren nach Anspruch 7, welches Verfahren **dadurch gekennzeichnet ist, dass** die metamorphe Abscheidung das Abscheiden einer Schicht aus Aluminiumarsenid (9) und die Oxidation dieser Schicht in einer seitlichen Zone (8), welche sich von der Achse (A) des Resonanzhohlraums entfernt, umfasst.

9. Verfahren nach Anspruch 7, welches Verfahren auf die Herstellung einer Bauteilmatrix angewendet wird, welche eine Vielzahl von optoelektronischen Bauteilen umfasst, die in einer Oberfläche dieser Matrix nebeneinander angeordnet sind, wobei bestimmte dieser Schritte der kollektiven Herstellung dienen, und durch das Abscheiden oder die Beseitigung wenigstens einer Schicht, die sich über die gesamte Oberfläche der Matrix erstreckt, realisiert werden, wobei eine durch einen kollektiven Herstellungsschritt abgeschiedene Schicht eine kollektive Schicht (46) bildet, der Schritt zur Bildung der Platte (P1) ein Schritt zur kollektiven Herstellung ist, das Verfahren ferner wenigstens einen Schritt zur Trennung umfasst, jeder Schritt zur Trennung eine örtliche Ätzung einer kollektiven Schicht umfasst um eine Vielzahl von Bereichen dieser kollektiven Schicht voneinander zu isolieren und um diese Bereiche jeweils für die herzustellenden optoelektronischen Komponenten bereitzustellen.

10. Verfahren nach Anspruch 9, wobei zur Bildung wenigstens eines unteren Spiegels die folgenden Schritte für jeden Resonanzhohlraum umfasst:
- lokales Angreifen des Substrats (1) von der unteren Seite (F1) der Platte (P1) her um eine einen Boden (21) aufweisende Ausnehmung (20) zu formen, wobei diese Ausnehmung genügend tief ist damit eine verringerte Stärke der Platte zwischen diesem Boden und der oberen Seite dieser Platte einer gewünschten Dicke für den Resonanzhohlraum gemäß der Achse (A) dieses Hohlraums gleich ist, wobei die Oberflächenabmessungen dieser Ausnehmung begrenzt sind, damit die durch diese Platte an der Außenseite dieser Ausnehmung gebildete Oberfläche (22) ausreicht um dieser Platte einen Bearbeitungsspielraum zu bewahren, und
- Abscheiden von aufeinanderfolgenden Schichten auf dem Boden (21) dieser Ausnehmung, wobei diese Schichten wechselnde Brechungsindizes aufweisen um einen unteren Spiegel (M1) zu bilden.

11. Verfahren nach Anspruch 10, wobei die Schichten des unteren Spiegels (M1) dielektrische Schichten sind.

12. Verfahren nach Anspruch 9, wobei die Bildung einer oberen Elektrode (15, 45) umfasst:
- einen Schritt zur kollektiven Herstellung, der durch das Abscheiden einer oberen Elektrodenschicht, welche eine kollektive Schicht bildet, erfolgt, und
- einen Schritt zur Trennung, welcher durch eine Ätzung der oberen Elektrodenschicht gebildet ist.

13. Verfahren nach Anspruch 12, wobei die Abscheidung wenigstens eines oberen Spiegels (13) umfasst:
- einen Schritt zur kollektiven Herstellung, welcher durch die Abscheidung der oberen Spiegelschichten erfolgt, und
- einen Schritt zur Trennung, der durch eine Ätzung dieser oberen Spiegelschichten gebildet ist.

14. Verfahren nach Anspruch 9, welches Verfahren **dadurch gekennzeichnet ist, dass** die Bildung wenigstens eines unteren Spiegels die Schritte zur kollektiven Herstellung umfasst, und die folgenden Schritte umfasst:
- Herstellung eines Trägers (50) mit einer unteren Seite (52) und einer oberen Seite (54), welcher eine Dicke aufweist, die ihm eine mechanische Festigkeit verleiht, nämlich eine Bearbeitungsfestigkeit,
- Platzieren dieses Trägers oberhalb der oberen Seite (F2) der Platte (P1),
- Befestigung dieses Trägers an dieser Platte durch eine Schmelzverbindung, wobei diese Schmelzverbindung durch Heißanlage der unteren Seite (52) dieses Trägers aufjeden oberen Spiegel (43) erfolgt,
- Angreifen der Platte (P1) von ihrer unteren Seite (F1) her um dieser Platte eine gewünschte Dicke für den Resonanzhohlraum zu geben, indem diese untere Seite durch eine neue untere Seite (F4) ersetzt wird, und
- Abscheiden von aufeinanderfolgenden Schichten auf diese neue untere Seite, wobei diese Schmelzverbindung durch Heißanlage der unteren Seite (52) dieses Trägers aufjeden oberen Spiegel (43) erfolgt,
wobei diese Schichten die kollektiven Schichten bilden und wechselnde Brechungsindizes aufweisen um jeden unteren Spiegel (wie M2) zu bilden.

15. Verfahren nach Anspruch 14, wobei der untere Spiegel (M2) ein Bragg-Spiegel ist, der gebildet ist durch die Abscheidung einer vertikalen Abfolge der metamorphen Schichten auf Basis von Galliumarsenid GaAs und einem Indexkontrastmaterial mit einem Brechungsindex, welcher von jenem des Galliumarsenids im wesentlichen verschieden ist, während es im Gitter auf Galliumarsenid abgestimmt ist, wobei diese Schichten untere Spiegelschichten bilden.

16. Verfahren nach Anspruch 14, wobei die Bildung einer unteren Elektrode (46) umfasst:
- einen Schritt zur kollektiven Herstellung, welcher durch das Abscheiden einer unteren Elektrodenschicht erfolgt, die eine kollektive Schicht bildet, und
- einen Schritt zur Trennung, der durch eine Ätzung der unteren Elektrodenschicht erfolgt.

17. Verfahren nach Anspruch 16, wobei die Abscheidung wenigstens eines unteren Spiegels (M2) umfasst:
- einen Schritt zur kollektiven Herstellung, der durch das Abscheiden der Schichten des unteren Spiegels erfolgt, und
- einen Schritt zur Trennung, der durch eine Ätzung dieser Schichten des unteren Spiegels erfolgt.

18. Verfahren nach Anspruch 15, welches Verfahren **dadurch gekennzeichnet ist, dass** der obere Spiegel (43) teilweise durchlässig ist und den zweiten Leitungstyp aufweist,
wobei der Träger (50) halbleitend und durchlässig ist und seinerseits auch den zweiten Leitungstyp aufweist, welcher Schritt zur Bildung einer oberen Elektrode umfasst:
- einen Schritt zur kollektiven Abscheidung, der durch das Abscheiden einer oberen Elektrodenschicht (45) auf die obere Seite (54) des Trägers (50) erfolgt, und
- einen Schritt zur Ätzung, welcher in dieser oberen Elektrodenschicht ein Fenster (56) für jedes Bauteil formt, wobei dieses Fenster sich um die Achse (A) des optischen Hohlraums dieses Bauteils erstreckt um den Durchtritt des Lichts dieses Bauteils zu ermöglichen.

19. Verfahren nach Anspruch 18, welches Verfahren **dadurch gekennzeichnet ist, dass** der Träger (50) aus Silizium gebildet ist.

20. Verfahren nach Anspruch 18, welches Verfahren **dadurch gekennzeichnet ist, dass** es ferner einen Schritt zur Bildung eines Wärmeableiters (58) für jedes Bauteil einschließt, wobei dieser Schritt erfolgt, indem eine Menge eines thermisch gut leitenden Materials auf die untere Seite (F1) der Platte auf den unteren Spiegel (M2) und/oder auf die untere Elektrode (46) dieses Bauteils abgeschieden wird.

21. Optoelektronisches Halbleiterbauteil umfassend:
- eine kristalline Platte (P1) mit dem Gitter von Indiumphosphid, und
- metamorphe Schichten { 13, 43, M1, M2), welche aus kristallisierbaren Materialien mit dem Gitter von Galliumarsenid gebildet sind und auf der Platte in Reihe mit dieser Platte auf einer funktionellen optischen Bahn (A) dieses Bauteils angeordnet sind, wobei die metamorphe Abscheidung wenigstens einen Halbleiterspiegel (13, M1) einer Laserstruktur bildet,
wobei dieses Bauteil **dadurch gekennzeichnet ist, dass** die kristalline Platte (P1) mit dem Gitter von Indiumphosphid die aktive Schicht (4) der Laserstruktur enthält.

22. Matrix von optoelektronischen Halbleiterbauteilen, welche Matrix **dadurch gekennzeichnet ist, dass** sie umfasst:
- eine kristalline Platte (P1) mit dem Gitter von lndiumphosphid, welche eine aktive Schicht (4) einer Laserstruktur enthält, und eine mechanisch Eigenfestigkeit hat, die kleiner ist als eine gewünschte mechanische Festigkeit für die Matrix,
- metamorphe Schichten (43, M2), die aus kristallisierbaren Materialien mit dem Gitter von Galliumarsenid gebildet sind, wobei diese metamorphen Schichten auf der Platte abgeschieden sind und in Reihe mit dieser Platte auf einer funktionellen optischen Bahn (A) von jedem der Bauteile der Matrix abgeschieden sind, und
- einen Träger (50), der aus einem Material gebildet ist, das verschieden von jenen der metamorphen Schichten und der Platte ist, wobei dieser Träger eine mechanische Festigkeit aufweist, die größer ist als die mechanische Festigkeit der Platte, und direkt an den metamorphen Schichten (43) durch eine Schmelzverbindung befestigt ist, um der Matrix die gewünschte mechanische Festigkeit zu verleihen.

## Claims

1. A process for fabricating semiconductor opto-electronic components including at least an operation of metamorphic deposition using an epitaxial deposition process to deposit at least one material (7, 9, 10, 13) that can be crystallized lattice matched to gallium arsenide onto a crystalline wafer (P1) lattice matched to indium phosphide so that said material forms at least one metamorphic layer (7, 9, 10, 13, 43) disposed in series with said wafer on a functional optical path (A) of said component, said metamorphic deposition forming at least one semiconductor mirror (13, M1) of a laser structure, said process being **characterized in that** said crystalline wafer (P1) lattice matched to indium phosphide contains the active layer (4) of said laser structure.

2. A fabrication process according to claim 1 including the operations of:
- forming said wafer (P1), said wafer having a thickness between a bottom face (F1) and a top face (F2), said thickness being sufficient to confer upon said wafer mechanical strength enabling manipulation of said wafer, said mechanical strength constituting a manipulation strength,
- forming at least one top mirror (13, 43) on said top face of said wafer, said top mirror being a Bragg mirror and being formed by depositing a vertical succession of said metamorphic layers consisting alternately of a material based on gallium arsenide AsGa and an index contrast material having a refractive index significantly different from that of gallium arsenide but lattice matched to gallium arsenide, said layers constituting top mirror layers,
- forming at least one bottom mirror (M1, M2) on said bottom face of said wafer to constitute a vertical resonant optical cavity having an axis (A) for each component to be fabricated, each resonant cavity comprising the combination of a bottom mirror and a top mirror facing each other along said axis, at least one of said top and bottom mirrors being partly transparent to enable said cavity to be optically coupled to a unit external to said component, and
- forming a bottom electrode (16, 46) and a top electrode (12, 15, 45) on said bottom face and said top face, respectively, of said wafer to enable application of an electrical control signal across said wafer for each component to be fabricated.

3. A process according to claim 2 **characterized in that** said metamorphic deposition operation begins with depositing a quaternary composition blocking layer (6).

4. A process according to claim 1 **characterized in that** said epitaxial deposition process is molecular beam epitaxy.

5. A process according to claim 2 **characterized in that** said metamorphic layers (P2) contain between 0.1 mole percent and 5 mole percent of indium.

6. A process according to claim 5 wherein said proportion of indium is between 0.5 mole percent and 1 mole percent.

7. A process according to claim 2, said wafer (P1) being formed by epitaxial deposition operations on a substrate (1, 31) having a first type of conductivity, said operations including in succession:
- depositing a doped bottom layer (3, 33) having said first type of conductivity,
- depositing an active layer (4, 34), and
- depositing a doped top layer (5, 35) having a second type of conductivity opposite to the first type to constitute an active structure.

8. A process according to claim 7 **characterized in that** a metamorphic deposition operation includes depositing a layer of aluminium arsenide (9) and oxidizing said layer in a lateral area (8) away from said axis (A) of the resonant cavity.

9. A process according to claim 7 applied to the fabrication of a matrix of components including a plurality of said opto-electronic components mutually juxtaposed in a surface of said matrix, certain of said operations being collective fabrication operations effected by depositing or eliminating at least one layer extending over all of said surface of the matrix, a layer deposited by a collective fabrication operation constituting a collective layer (46), said operation of forming said wafer (P1) being a collective fabrication operation, said process further including at least one separation operation, each separation operation including localized etching of a collective layer in order mutually to isolate a plurality of areas of said collective layer and to allocate said areas to respective opto-electronic components to be fabricated.

10. A process according to claim 9, said operation of forming at least a bottom mirror including the following operations for each resonant cavity:
- locally etching said substrate (1) from said bottom face (F1) of the wafer (P1) to form a recess (20) having a bottom (21), said recess being sufficiently deep for a reduced thickness of said wafer between said bottom and said top face of said wafer to be equal to a required thickness for said resonant cavity along said axis (A) of said cavity, surface dimensions of said recess being limited so that a surface (22) of said wafer outside said recess is sufficient to preserve a manipulation strength of said wafer, and
- depositing successive layers onto bottom (21) of said recess, said layers having alternating refractive indices in order to constitute a bottom mirror (M1).

11. A process according to claim 10 wherein said bottom mirror (M1) layers are dielectric layers.

12. A method according to claim 9, said operation of forming a top electrode (15, 45) including:
- a collective fabrication operation effected by depositing a top electrode layer constituting a collective layer, and
- a separation operation consisting in etching said top electrode layer.

13. A process according to claim 12, said operation of depositing at least one top mirror (13} including:
- a collective fabrication operation effected by depositing said top mirror layers, and
- a separation operation consisting in etching said top mirror layers.

14. A process according to claim 9 **characterized in that** said operation of forming at least one bottom mirror includes collective fabrication operations including:
- preparing a support (50) having a bottom face (52) and a top face (54) and having a thickness conferring upon it mechanical strength constituting said manipulation strength,
- placing said support on top of said top face (F2) of said wafer (P1),
- fixing said support to said wafer by wafer fusion, said wafer fusion being effected by pressing said bottom face (52) of said support onto each top mirror (43) at raised temperature,
- etching said wafer (P1) from said bottom face (F1) to confer on said wafer a required thickness for said resonant cavity by replacing said bottom face by a new bottom face (F4), and
- depositing successive layers on said new bottom face, said layers constituting collective layers and having alternating refractive indices to constitute each bottom mirror (such as M2).

15. A process according to claim 14, said bottom mirror (M2) being a Bragg mirror formed by depositing a vertical succession of metamorphic layers based on gallium arsenide AsGa and an index contrast material having a refractive index significantly different from that of gallium arsenide and Lattice matched to gallium arsenide, said layers constituting bottom mirror layers.

16. A process according to claim 14, said operation of forming a bottom electrode (46} including:
- a collective fabrication operation effected by depositing a bottom electrode layer constituting a collective layer, and
- a separation operation consisting in etching said bottom electrode layer.

17. A process according to claim 16, said operation of depositing at least a bottom mirror (M2) including:
- a collective fabrication operation effected by depositing said bottom mirror layers, and
- a separation operation consisting in etching said bottom mirror layers.

18. A method according to claim 15 **characterized in that** said top mirror (43) is partly transparent and has the second type of conductivity, said support (50) being a semiconductor and transparent and also having said second type of conductivity, said operation of forming a top electrode including:
- a collective deposition operation effected by depositing a top electrode layer (45) on said top face (54) of the support (50), and
- an etching operation forming a window (56) for each component in said top electrode layer, said window extending around said axis (A) of the optical cavity of said component to enable light to exit said component.

19. A process according to claim 18 **characterized in that** said support (50) is made of silicon.

20. A process according to claim 18, **characterized in that** it further includes an operation of forming a heatsink (58) for each component, said operation being effected by depositing a mass of material that is a good conductor of heat onto said bottom face (F1) of the wafer, onto said bottom mirror (M2) and/or onto said bottom electrode (46) of said component.

21. A semiconductor opto-electronic component including:
- a crystalline wafer (P1) lattice matched to indium phosphide, and
- metamorphic layers (13, 43, M1, M2) constituted of materials that can be crystallized lattice matched to gallium arsenide, disposed on said wafer in series with said wafer on a functional optical path (A) of said component, said metamorphic deposition forming at least one semiconductor mirror (13, M1) of a laser structure, said component being **characterized in that** said crystalline wafer (P1) lattice matched to indium phosphide contains the active layer (4) of said laser structure.

22. A matrix of semiconductor opto-electronic components **characterized in that** it includes:
- a crystalline wafer (P1) lattice matched to indium phosphide containing an active layer (4) of a laser structure and having an inherent mechanical strength less than a required mechanical strength of said matrix,
- metamorphic layers (43, M2) constituted of materials that can be crystallized lattice matched to gallium arsenide, said metamorphic layers being deposited on said wafer and being disposed in series with said wafer on a functional optical path (A) of each component of said matrix, and
- a support (50) made of a material different from those of said metamorphic layers and said wafer, said support having a mechanical strength greater than said mechanical strength of the wafer and being fixed directly to said metamorphic layers (43) by wafer fusion to confer said required mechanical strength on said matrix.
